# NEUE EUROPÄISCHE PATENTSCHRIFT

(11) **EP 2 460 022 B2**
(45) Veröffentlichungstag und Bekanntmachung des Hinweises auf die Entscheidung über den Einspruch: **26.10.2022**
(45) Hinweis auf die Patenterteilung: 06.05.2020
(21) Anmeldenummer: 10734106.7
(22) Anmeldetag: 14.07.2010
(51) Int. Cl.: B60L 53/31, B60L 3/00, B60L 3/04, G01R 31/00, H02J 7/00, B60L 53/14

(54) **Einrichtung und Verfahren zur Bereitstellung elektrischer Energie an einen Verbraucherstromkreis**
Device and method for providing electrical energy at a branch circuit supplying a load
Dispositif et procédé pour fournir de l'énergie éléctrique à un circuit de branchement alimentant une charge

(30) Priorität: 27.07.2009 EP 09166491; 27.07.2009 DE 102009034887
(43) Veröffentlichungstag der Anmeldung: 06.06.2012
(73) Patentinhaber: Compleo Charging Solutions AG, 44309 Dortmund (DE)
(72) Erfinder: GAUL, Armin, 59379 Selm (DE); DIEFENBACH, Ingo, 59425 Unna (DE)
(74) Vertreter: Gottschald Patentanwälte Partnerschaft mbB
(86) Internationale Anmeldenummer: PCT/EP2010/060164
(87) Internationale Veröffentlichungsnummer: WO 2011/012450

(56) Entgegenhaltungen:
- DE-A1- 3 743 034
- DE-A1- 3 743 064
- DE-A1- 10 151 163
- DE-U1-202008 009 929
- US-A1- 2006 238 932
- US-B1- 6 330 516
- VDE 0160/DIN EN 50178 (Veröffentlichungsstand: April 1998)
- Protokoll des Arbeitskreises ?Produktnorm DIN EN 62196" vom 08.04.2009
- Arbeitskreisfassung der IEC 62196 vom 08.04.2009
- DKE-Ausschussschreiben vom 18.06.2009 mit Anlage IEC 61851
- DIN EN 62196 (Produktnorm "Stecker-Typ 2", Veroffentlichungsstand Februar 2010)
- ESSER, W.: "Schalt- und Schutzgeräte in Maschinensteuerungen. Elekt- ropraktiker", FUR DIE PRAXIS, vol. 11, 2003, pages 862-865, Berlin
- Anonymous: "Trennschalter", Wikipedia, 7 January 2021 (2021-01-07), pages 1-3, Retrieved from the Internet: URL:https://de.wikioedia.org/wiki/Trennsch alter
- SPECOVIUS, J.: "Chapter 4" In: "Grundkurs Leistungselektronik", 2008 vol. 2, pages 33-42,
- Anonymous: "Elektronik Tabelle. Betriebs- und Automatisierungstechnik.", Westermann, 2007, pages 1-3,

## Beschreibung

Die vorliegende Erfindung betrifft ein Verfahren und eine Vorrichtung zur Bereitstellung von an einen Verbraucher zu liefernder elektrischer Energie, insbesondere zur Bereitstellung von an ein Elektrofahrzeug zu liefernder elektrischer Energie sowie ein System bestehend aus einer Ladestation und einem Elektrofahrzeug und eine Verwendung für den Ladevorgang eines Elektrofahrzeuges.

Der Sicherheitsaspekt spielt im Zusammenhang mit der Versorgung von elektrischen Verbrauchern, insbesondere von Elektrofahrzeugen eine zentrale Rolle. Es ist bekannt, eine Versorgungseinrichtung, die insbesondere die Ladestation für ein Elektrofahrzeug darstellen kann, mit einer Vielzahl unterschiedlicher Komponenten zu bestücken, deren einzelne Funktion im Folgenden beschrieben wird:
Zunächst muss die Versorgungseinrichtung über einen auch als "Stromzähler" bekannten Energiemengenzähler verfügen, mit dem die vom Energieversorgungsunternehmen bezogene elektrische Energiemenge erfasst und zur Weiterberechnung zur Verfügung gestellt wird.

Solche Zähler erfassen den im Stromnetz jeweils bereit gestellten Phasenstrom sowie die anliegende Spannung. Sie ermitteln daraus durch Multiplikation und Integration über die Zeit die genutzte Wirk-Energiemenge in der Einheit Kilowattstunden.

Am meisten verbreitet sind sogenannte "Ferraris-Zähler", welche nach dem Induktionsprinzip arbeiten. Hierbei wird durch den Ein- oder Mehrphasenwechselstrom sowie die Netzspannung in einer Aluminiumscheibe ein magnetisches Drehfeld induziert, welches in dieser durch Wirbelströme ein Drehmoment erzeugt. Dieses Drehmoment ist proportional zum Vektor-Produkt aus Strom und Spannung. Die Aluminiumscheibe läuft in einer aus einem Dauermagnet bestehenden Wirbelstrombremse, die ein geschwindigkeitsproportionales Bremsmoment erzeugt. Die Aluminiumscheibe, deren Kante als Ausschnitt durch ein Fenster von außen sichtbar ist, hat dadurch eine Drehgeschwindigkeit, welche zur elektrischen Wirkleistung proportional ist. Mit der Aluminiumscheibe ist ein Rollenzählwerk verbunden, so dass der Energiedurchsatz als Zahlenwert in Kilowattstunden (kWh) abgelesen werden kann.

Bei Tarifkunden, zum Beispiel in privaten Haushalten, werden solche elektro-mechanischen Energiezähler mit zwei und mehr Zählwerken eingesetzt, um zeitbezogen unterschiedliche Tarife abrechnen zu können. Zwischen diesen Zählwerken wird beispielsweise durch eingebaute oder externe Rundsteuerempfänger, die durch zentrale Rundsteueranlagen im Energieversorgungsunternehmen gesteuert werden, umgeschaltet. So kann der Energieverbrauch in Zeiten schwacher Netzbelastung, beispielsweise nachts, für den Verbraucher günstiger abgerechnet werden.

Bereits bekannt sind auch digitale elektronische Energiezähler (sogenannte "Smart Meter"), die keine mechanisch bewegten Elemente enthalten. Der Strom wird durch Stromwandler, beispielsweise mit einem weichmagnetischen Ringkern oder einem Strommesssystemen mit Rogowskispulen mittels Nebenschlusswiderstand (Shunt) oder durch Hallelemente erfasst. Die Berechnung der Energie erfolgt über eine elektronische Schaltung. Das Ergebnis wird einer alphanumerischen Anzeige, z.B. einer Flüssigkristallanzeige (LCD), zugeführt. Solche digitalen elektronischen Energiezähler weisen den besonderen Vorteil der Fernablesbarkeit auf und machen daher die bislang übliche jährliche Ablesung überflüssig, da die Zählerdaten elektronisch, beispielsweise über das Internet, an den Stromanbieter übermittelt werden.

Als Datenschnittstellen für die Datenübertragung zur Abrechnungseinheit des Energieversorgungsunternehmens sind verschiedene Varianten gebräuchlich, z.B. Infrarot, S0-Schnittstelle, M-Bus, Potentialfreier Kontakt, EIB/KNX, oder Power Line Communication (PLC), bei der Daten über die normale Netzleitung übertragen werden.

Darüber hinaus verfügt eine Versorgungseinrichtung für einen Verbraucher wie bekannt über Überwachungseinrichtungen, um deren ordnungsgemäßen Betrieb sicher zu stellen sowie um gegebenenfalls bei einer Überlastung der Versorgungseinrichtung entsprechende Schutzmaßnahmen einzuleiten. Hinsichtlich ihrer Funktionalität handelt es sich dabei um Schaltmittel, die zum Verbinden oder Trennen des Verbraucherstromkreises dienen, um Sicherungsmittel, die die Stromkreise vor Beschädigung schützen sollen infolge zu starker Leitungserwärmung oder Kurzschlüssen, sowie um Fehlerstromüberwachungsmittel.

Ein Schaltmittel ist in bekannter Weise als ein elektromagnetisch betätigter Schalter ("Schütz") ausgebildet, bei dem ein Steuerstrom durch eine Magnetspule fließt, wobei durch die magnetische Anziehung mechanisch ein Kontakt betätigt wird, der den Hauptstromkreis schließt. Solange der Steuerstrom fließt, wird die Einschaltstellung gehalten. Schütze unterscheiden sich von Relais durch höhere Schaltleistungen.

Als Fehlerstromüberwachungsmittel sind insbesondere sogenannte FI-Schalter (auch bezeichnet als RCD *"Residual Current protective Device"*) bekannt, welche bei Überschreiten einer bestimmten Differenzstromstärke (in Hausanlagen meist 30 mA) den überwachten Stromkreis allpolig, d. h. in Bezug auf alle Leiter außer dem Schutzleiter, vom restlichen Netz trennen.

Dazu vergleicht der RCD die Höhe des hin- mit dem des zurückfließenden Stromes. Die vorzeichenbehaftete Summe aller durch den RCD fließenden Ströme muss bei einer intakten Anlage Null betragen. Der Vergleich erfolgt in einem SummenStromwandler, der alle zum und vom Verbraucher fließenden Ströme vorzeichenrichtig addiert. Wird irgendwo im Stromkreis ein Strom gegen Erde abgeleitet, so ist im Summenstromwandler die Summe von hin- und zurückfließendem Strom ungleich Null: es entsteht eine Stromdifferenz ΔI, die zum Ansprechen des RCD und damit zur Abschaltung der Stromzufuhr führt.

Fehlerstromschutzeinrichtungen vom Typ AC (wechselstromsensitiv) erfassen nur rein sinusförmige Fehlerströme. In der Praxis sind daher pulsstromsensitive Fehlerstromschutzeinrichtungen vom sog. "Typ A" üblich. Diese erfassen rein sinusförmige Wechselströme sowie pulsierende Gleichfehlerströme. Diese zusätzliche Sensibilität wird durch spezielle Magnetwerkstoffe für die eingesetzten Ringbandkerne erreicht. Pulsstromsensitive Fehlerstromschutzeinrichtungen arbeiten netzspannungsunabhängig.

Betriebsmittel der Leistungselektronik, wie z.B. Frequenzumrichter, Wechselrichter, unterbrechungsfreie Stromversorgungen (USV), Schaltnetzteilen oder Phasenanschnittsteuerungen, erzeugen eine bipolare, pulsweiten-modulierte Ausgangsspannung, welche Schaltfrequenzen im Bereich von bis zu 20 kHz aufweist. Im Fehlerfall können diese Betriebsmittel - neben 50 Hz-Wechsel- und Pulsgleichfehlerströmen - auch glatte Gleichfehlerströme und Wechselfehlerströme unterschiedlichster Frequenzen sowie Mischfrequenzen (bei Frequenzumrichtern z.B. die Schaltfrequenz und Ausgangsfrequenz) verursachen. FI-Schutzschalter vom Typ A können diese Fehlerströme nicht exakt erfassen, so dass eine ordnungsgemäße Auslösung des FI-Schutzschalters nicht gewährleistet ist. Daher ist gemäß VDE 0160/EN 50178 »Ausrüstung von Starkstromanlagen mit elektronischen Betriebsmitteln«, Abs. 5.2.11.2 und 5.3.2.3 zum Schutz bei direktem und indirektem Berühren eine RCD vom "Typ B" einzusetzen, wenn ein elektronisches Betriebsmittel einer elektrischen Anlage im Fehlerfall einen glatten Gleichfehlerstrom erzeugen kann.

Solche sog. allstromsensitiven Fehlerstromschutzschalter ("Typ B") enthalten einen zweiten Summenstromwandler zur Erfassung glatter Gleichfehlerströme. Eine Elektronikeinheit gibt bei einem Fehler den Abschaltbefehl an den Auslöser weiter. Die Überwachung auf Gleichfehlerströme erfolgt netzspannungsabhängig. Eine solche Einrichtung benötigt also eine Versorgungsspannung, welche aus den Außenleitern und ggf. dem Neutralleiter abgenommen wird. Der pulsstromsensitive Schalterteil ist davon unabhängig und arbeitet wie bei Typ A netzspannungsunabhängig.

Fehlerstromschutzschalter der beschriebenen Art benötigen Sensoren zur hochgenauen Erfassung des Stromes und zur Weiterverarbeitung des Messsignals. Darüber hinaus ist vorgeschrieben, dass FI- Schalter in bestimmten Zeitabschnitten geprüft werden müssen. Dazu werden sie entweder von Hand oder von dazu vorgesehenen Zusatzeinrichtungen betätigt.

Schließlich sind als dritte Komponente in einer Überwachungseinrichtung einer Versorgungseinrichtung Überstromschutzeinrichtungen in Form von Leitungsschutzschaltern (LS-Schalter oder MCB *"Miniature Circuit* Breaker")bekannt. Leitungsschutzschalter sind wiederverwendbare, nicht selbsttätig rückstellende Sicherungselemente, welche den Stromkreis bei Überlast selbsttätig abschalten. Solche Einrichtungen schützen Leitungen vor Beschädigung durch zu starke Erwärmung, die aus dem über einen längeren Zeitraum fließenden Überstrom resultieren würde.

Ein Überstrom kann durch eine Überlast oder einen Kurzschluss verursacht werden. Bei einer Auslösung bei Überlast erfolgt die Abschaltung, wenn der vorgegebene Nennwert des durch den Leitungsschutzschalter fließenden Stromes längere Zeit erheblich überschritten wird. Die Zeit bis zur Auslösung hängt von der Stärke des Überstroms ab - bei hohem Überstrom ist sie kürzer als bei geringer Überschreitung des Nennstromes. Zur Auslösung wird ein Bimetall verwendet, das sich bei Erwärmung durch den durchfließenden Strom biegt und den Abschaltmechanismus auslöst. Die Reaktionszeit einer Überstromschutzeinrichtung bei unterschiedlichen Stromstärken wird als Charakteristik bezeichnet und in Strom-Zeit-Kennlinien dargestellt.

Im Falle des Auftretens eines Kurzschlusses in der Anlage muss eine sehr schnelle Auslösung, zumeist innerhalb weniger Millisekunden, durch einen vom Strom durchflossenen Elektromagneten des Leitungsschutzschalters erfolgen. Hierzu sind Sensoren für eine entsprechende Erfassung und Schaltungsmittel zur Weiterverarbeitung des Messsignals notwendig. Auch lassen sich Leitungsschutzschalter manuell auslösen, z.B. für Wartungsarbeiten oder zur vorübergehenden Stilllegung. Dazu befindet sich ein Kippschalter oder ein Auslöseknopf auf der Frontseite des Schalters.

Es ist auch bekannt, einen Leitungsschutzschalter mit einem FI-Modul zu kombinieren, um zu erreichen, dass beim Detektieren einer Fehlerstromsituation durch das FI-Modul eine Leitungsstilllegung durch den Leitungsschutzschalter erfolgen kann.

Die oben beschriebenen Überwachungs- bzw. Sicherungseinrichtungen werden in Form der beschriebenen einzelnen Komponenten in der Praxis vielfältig eingesetzt. Dabei werden einzelne Stromkreise oder Verbraucherzweige, welche eine Fülle unterschiedlicher elektrischer Verbraucher enthalten, jeweils durch entsprechend dimensionierte Komponenten abgesichert. Dabei werden in unterschiedlichen Zweigen entsprechende, zumeist ein hierarchisches Sicherheitskonzept aufweisende Dimensionierungen der Komponenten vorgenommen. Dabei erfolgt auch eine Absicherung auf unterschiedlichen Spannungsebenen eines Netzes getrennt voneinander.

Einschlägige Vorrichtungen zur Bereitsstellung elektrischer Energie sind aus den Dokumenten US 2006/238932 A1, DE 101 51 163 A1 und DE 20 2008 009929 U1 (nachveröffentlicht) bekannt.

Der vorliegenden Erfindung liegt demgegenüber die Aufgabe zugrunde, ein Überwachungs- und Sicherheitskonzept zu entwickeln, welches für einen solchen Anwendungsfall geeignet ist, bei dem ein einzelner elektrischer Energieverbraucher eine speziell auf seinen Verbraucherkreis zugeschnittene, von übrigen Verbrauchern unabhängige Absicherung erfahren soll.

Diese Aufgabe wird durch eine Vorrichtung gemäß unabhängigem Anspruch 1 und ein Verfahren gemäß unabhängigem Anspruch 11 gelöst.

Die erfindungsgemäße Lösung zeichnet sich dadurch aus, dass gegenüber dem bekannten, eingangs beschriebenen Absicherungskonzept bestehend aus einzelnen Überwachungseinrichtungen eine Vielzahl von Sensoren bzw. funktionellen Baugruppen eingespart werden können, wenn ein auf die Absicherung eines einzelnen Verbraucherkreises zugeschnittenes Konzept verfolgt wird. Hierdurch ergeben sich entsprechende Material- und damit Kosteneinsparungen, da auf Mehrfachfunktionalitäten verzichtet werden kann. Durch das Vorsehen einer weitgehend wahlfreien Parametrierung für das mindestens eine Auslösekriterium wird dabei auch der bei bekannten Überstromschutzeinrichtungen bestehende Nachteil beseitigt, dass z.B. ein Leitungsschutzschalter hinsichtlich seiner Sicherungskennlinie (Strom-Zeit-Charakteristik) nur unzureichend parametriert werden kann, da die Kennlinie im wesentlichen durch die Materialeigenschaften des verwendeten Bimetalls bestimmt ist. Von besonderer Bedeutung dabei ist auch, dass hierdurch eine Integration dahin gehend erreichbar ist, dass nur noch ein einziger Schalter benötigt wird, welcher den verschiedenen Funktionen (Fehlerstromüberwachung, Überstromüberwachung, Abschalten als Schütz) wahlfrei zugeordnet werden kann.

Weitere Vorteile der erfindungsgemäßen Lösung ergeben sich entsprechend den in den abhängigen Patentansprüchen dargestellten Ausführungsformen: Dadurch, dass die Sicherungs- und Überwachungseinrichtung ein Überstromüberwachungsmittel aufweist, welches die Größe und/oder den zeitlichen Verlauf des bereitgestellten elektrischen Stromes detektiert, lässt sich die Funktionalität eines Leitungsschutzschalters simulieren.

Wenn von den Parametrierungsmitteln ein im Verbraucherstromkreis maximal zulässiger Stromwert vorgebbar ist, ergibt sich ein wirksamer Überstromschutz im Kurzschlussfall.

Dadurch, dass die Strom- Zeitcharakteristik einer vorgebbaren Sicherungskennlinie entspricht, lässt sich das Verhalten eines Leitungsschutzschalters für thermische Überlastabsicherung simulieren, und zwar mit gegenüber herkömmlichen passiven Leitungsschutzschaltern erheblich verbesserter Variabilität.

Dadurch, dass die Sicherungs- und Überwachungseinrichtung ein Fehlerstromüberwachungsmittel aufweist, lässt sich die Funktionalität eines FI Schalters simulieren, wobei sowohl das Auftreten eines Wechselstrom-Fehlerstroms (FI-Schalter des Typs A) als auch das Auftreten eines Gleichstrom-Fehlerstroms (FI-Schalter des Typs B) überwacht werden kann.

Als Sensormittel kommen bevorzugt sowohl ein Hallsensor als auch ein Stromwandler in Frage.

Die Schalteinrichtung ist ein Leistungsstromschalter in Form eines Relais und/oder eines Schützes.

In einer Ausgestaltung der erfindungsgemäßen Vorrichtung ist der Sicherungs- und Überwachungseinrichtung ein von einer Energieversorgungseinrichtung gespeister Energiemengenzähler vorgeordnet, so dass die vom Verbraucher aufgenommene Energiemenge erfasst und dokumentiert werden kann.

Von Besonderheit ist auch, dass jedem Verbraucher eine separate Sicherungs- und Überwachungseinrichtung zugeordnet sein kann, wodurch sich eine Optimierung sowohl im Kostenaufwand als auch in der Adaptierbarkeit ergibt. Dabei ist jedem Verbraucher ein separater Energiemengenzähler zugeordnet, wodurch jede Einheit als autarkes Einzelsystem ("Stand-alone") zu betrachten ist.

Weitere besondere Charakteristika der erfindungsgemäßen Lösung sind darin zu sehen, dass die Sicherungs- und Überwachungseinrichtung eine telemetrische Funktion aufweisen kann. Von besonderer Bedeutung ist die Möglichkeit der Fernwartung und der Überwachung von Fehlfunktionen oder Fehlerbedingungen. Z.B. wird ein Fernwiedereinschalten nach dem Auslösen des Schaltmittels ermöglicht. Eine besondere Sicherheitsfunktion ist auch darin zusehen, dass im Fehlerfall ein Stromlosfallen durch Abschalten aller Phasen erreicht werden kann. Dies ist von Wichtigkeit, wenn keine Fremdspeisung des Überwachungsmittels vorliegt.

In einer weiteren Ausgestaltung der erfindungsgemäßen Lösung ist vorgesehen, dass die Sicherungs- und Überwachungseinrichtung als eines ihrer Eingangssignale das Pilotsignal einer Ladesteuerungsschaltung der Ladestationen erhält, oder alternativ dazu, dass die Sicherungs- und Überwachungseinrichtung als eines ihrer Eingangssignale das "Plug Present" Signal einer Ladesteuerungsschaltung erhält.

Nachfolgend wird der Gegenstand anhand einer ein Ausführungsbeispiel zeigenden Zeichnung näher erläutert. In der Zeichnung zeigen:
- Fig. 1: ein Blockschaltbild für den Aufbau eines bekannten Systems bestehend aus einem Verbraucher und einer über ein Anschlussmittel damit verbundenen Versorgungseinrichtung;
- Fig. 2: ein Detail zu dem Energiemengenzähler entsprechend dem in Fig. 1 dargestellten Ausführungsbeispiel;
- Fig. 3: eine Blockschaltbild einer Überwachungs- und Sicherungseinrichtung einer Versorgungseinrichtung für ein Verbraucher nach dem Ausführungsbeispiel der Erfindung;
- Fig.4: eine Detaildarstellung zu einer Überwachungs- und Sicherungseinrichtung einer Versorgungseinrichtung nach Figur 3.

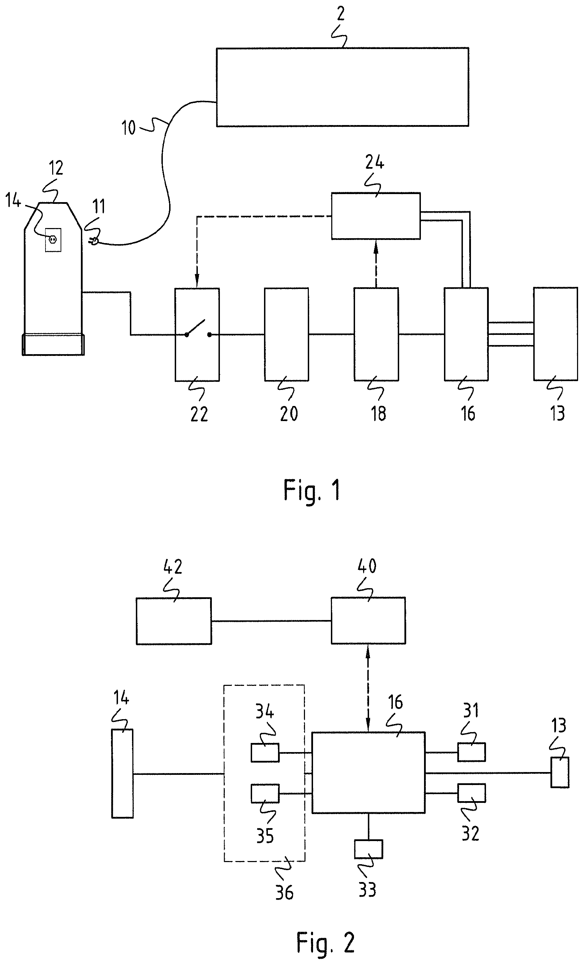

Fig. 1 zeigt einen Verbraucher 2, welcher ein elektrischer Verbraucher in Form eines Elektrofahrzeuges sein kann, der über ein Anschlussmittel 10, z.B. ein Kabel mit einer Versorgungseinrichtung 12 in Form einer Ladestation verbunden sein kann.

Die Ladestation 12 weist eine Steckdose 14, Überwachungs- und Sicherungskomponenten 18, 20, 22, sowie einen Energiemengenzähler 16 auf, welcher an den Anschlusskasten eines Energieversorgungsnetzes 13 angeschlossen ist. Während des Ladens der Batterie des Fahrzeugs 2 über das Kabel 10 fließt Strom von dem Energieversorgungsnetz 13 über den Zähler 16 und die Steckdose 14 sowie das Kabel 10, den Zähler 16 und das Ladegerät 6 in die Batterie. Der Zähler 16 zählt die in die Batterie fließende Energiemenge.

Bei den Überwachungs- und Sicherungskomponenten handelt es sich um einen FI-Schalter 18, um einen passiven Leitungsschutzschalter 20 und um ein Schütz 22 zum gesteuerten Ein- bzw. Ausschalten des Laststromkreises.

Die Steuerung des Schützes 22 erfolgt über einen Ladestations-Gateway-Rechner 24. Der Leitungsschutzschalter 20 arbeitet in bekannter Weise, d.h. es handelt sich um eine Komponente, welche den Stromkreis bei Überlast selbsttätig abschaltet. Damit wird der Laststromkreis vor Beschädigung durch zu starke Erwärmung geschützt, die aus dem über einen längeren Zeitraum fließenden Überstrom resultieren würde, wobei der Überstrom entweder durch eine Überlast oder durch einen Kurzschluss verursacht werden kann. Bei einer Auslösung bei Überlast erfolgt die Abschaltung, wenn der vorgegebene Nennwert des durch den Leitungsschutzschalter fließenden Stromes längere Zeit überschritten wird. Die Zeit bis zur Auslösung hängt von der Stärke des Überstroms ab und richtet sich nach der in einer Strom-Zeit- Kennlinie dargestellten Charakteristik.

Im Falle des Auftretens eines Kurzschlusses in der Anlage erfolgt eine sehr schnelle Auslösung, zumeist innerhalb weniger Millisekunden. Auch lässt sich der Leitungsschutzschalter 20 manuell auslösen, z.B. für Wartungsarbeiten oder zur vorübergehenden Stilllegung. Dazu befindet sich ein Kippschalter oder ein Auslöseknopf auf der Frontseite des Schalters 20. Nach dem Auslösen lässt sich der Schalter 20 vom Bediener der Ladestation manuell wieder einschalten.

Auch der FI-Schalter 18 ist wie im Stand der Technik bekannt mit einer externen mechanischen Tastenbetätigung versehen, um entsprechende manuelle Prozeduren durchführen zu können. Solche manuellen Prozeduren können in Bezug auf den FI-Schalter 18 routinemäßige Tests sein.

Wie aus Figur 2 hervorgeht, enthält der Energiemengenzähler 16 eingangsseitig, d.h. an seinem dem Energieversorgungsnetz 13 zugewandten Anschluss, einen ersten Detektor 31 für die an diesem Messpunkt anliegende Phasenspannung sowie einen zweiten Detektor 32 für den in den Zähler 16 fließenden Phasenstrom. Die Detektoren 31, 32 sind als Detektoren für die entsprechenden elektrischen Größen, z.B. als Ringkern-Stromwandler, Hallsensoren etc. ausgebildet. Aus den Ausgangssignalen der Detektoren 31, 32 wird die über einen bestimmten Zeitraum gelieferte Energiemenge berechnet und diese kann auf einer Anzeigevorrichtung 33 des Zählers 16 zur Anzeige gebracht werden.

Der Zähler 16 ist ein fernauslesbarer Zähler, welcher über ein Kommunikationsnetz 40 mit einer Abrechnungszentrale 42 verbunden ist. Das Kommunikationsnetz 40 kann Teil des Energieversorgungsnetzes 13 sein, so dass beispielsweise eine Kommunikation mittels Power-Line-Communication über das Energieversorgungsnetz 13 erfolgen kann. Auch kann das Kommunikationsnetz 40 ein drahtgebundenes oder drahtloses Kommunikationsnetz sein. Zur Kommunikation kann beispielsweise ein IP-Protokoll verwendet werden.

Der Zähler 16 weist ausgangsseitig nicht nur eine Anzeigeeinrichtung 34 für die berechnete Energiemenge sondern auch eine weitere Ausgabeeinheit 35 für den Phasenstrom auf, welcher über den Detektor 32 erfasst wird. Die weitere Ausgabeeinheit 35 kann den Messwert des Detektors 32 unmittelbar ausgeben oder ein aus diesem Messwert abgeleitetes weiterverarbeitetes Signal. Alternativ dazu kann von der weiteren Ausgabeeinheit 35 auch die Phasenspannung oder ein entsprechend weiter verarbeitetes Signal des Detektors 31 ausgegeben werden. Schließlich ist auch die Ausgabe eines aus den Signalen der Detektoren 31 und 32 gemeinsam abgeleiteten Ausgangssignals, insbesondere die Phasenwirkleistung, von der weiteren Ausgabeeinheit 35 darstellbar.

Der weiteren Ausgabeeinheit 35 ist ebenso wie der Ausgabeeinheit 34 für die gemessene Energiemenge eine Datenschnittstelle 36 zugeordnet, wobei diese Datenschnittstelle separat oder gemeinsam (wie in Fig. 2 dargestellt) mit der Datenschnittstelle für die Energiemenge ausgebildet sein kann.

Über die Datenschnittstelle 36 steht der Phasenstrom oder ein anderes elektrisches Signal für die weitere Verarbeitung im Zusammenhang mit der im folgenden beschriebenen Überwachungs- bzw. Sicherheitseinrichtung zur Verfügung.

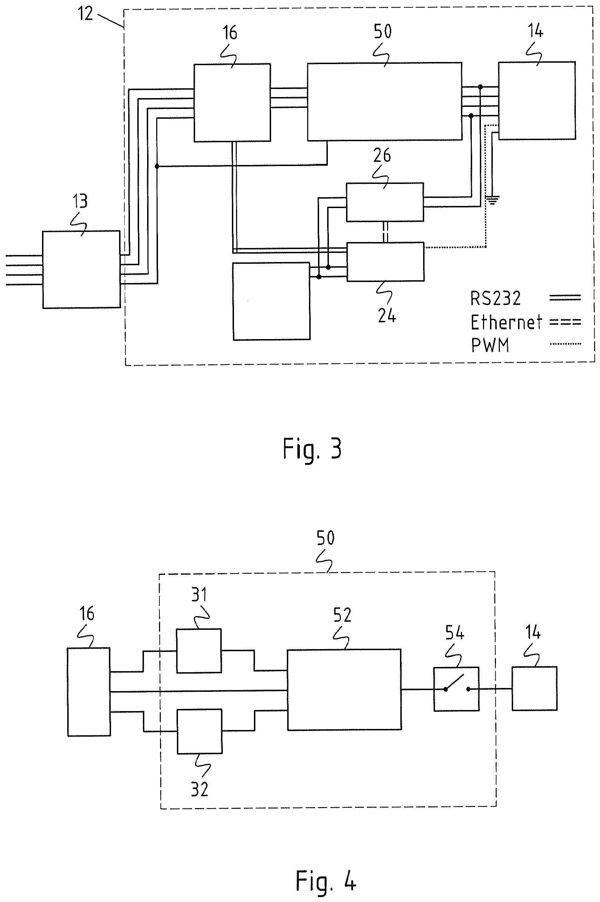

Der Aufbau einer Ladestation für Elektrofahrzeuge nach dem vorliegenden Ausführungsbeispiel der Erfindung wird im Zusammenhang mit Figur 3 wie folgt erläutert:
Die vom Energieversorgungsnetz 13 führende elektrische Versorgungsleitung, bei der es sich um eine dreiphasige Drehstromleitung handeln kann, mündet in einem innerhalb der Ladestation 12 angeordneten Anschlusskasten. Von dort sind die Leitungen weitergeführt auf den "Stromzähler" 16, welcher bevorzugt als ein wie oben im Zusammenhang mit Figur 2 dargestellter digitaler Energiemengenzähler ausgeführt ist und dessen Ausgabewert über eine als RS 232 Schnittstelle ausgeführte serielle Schnittstelle oder eine sonstige serielle oder parallele Schnittstelle zur Auswertung der erfassten Energiemenge an einen Ladestations-Gateway-Rechner (LSG) 24 weitergegeben wird. Vom Energiemengenzähler 16 ausgehend sind die Leitungen dreiphasig weitergeführt auf eine integrierte digitale Überwachungs- und Sicherungseinrichtung 50.

Ausgangsseitig der integrierten digitalen Überwachungs- und Sicherungseinrichtung 50 befindet sich die Steckdose 14 der Ladestation, über welche dem Elektrofahrzeug 2 unter Zuhilfenahme des Ladekabels 10 die gewünschte Energie bereitgestellt wird.

Die Kommunikation zwischen der Steckdose 14 und dem Ladestations-Gateway-Rechner LSG 24 erfolgt z.B. über PWM-Technik, während die Kommunikation zwischen dem Ladestations-Gateway-Rechner 24 und dem Powerline-Kommunikations-Modul PLC 26 über beispielsweise das Ethernet-Protokoll stattfindet.

Der grundsätzliche Aufbau der integrierten digitalen Überwachungs- und Sicherungseinrichtung 50 ist im Zusammenhang mit Figur 4 dargestellt: Die Einrichtung 50 beinhaltet eine Auswerteeinrichtung 52, an deren Eingang die Ausgangsignale von Sensoren 31, 32 für elektrische Signale, insbesondere für den Phasenstrom und die Phasenspannung anliegen. Bei diesen Sensoren 31, 32 kann es sich beispielsweise um diejenigen Komponenten handeln, welche auch die Eingangssignale für den im Zusammenhang mit Figur 2 beschriebenen Energiemengenzähler bilden.

Die elektrischen Eingangsgrößen werden hinsichtlich ihrer Amplitude und des zeitlichen Verlaufs innerhalb der Auswerteschaltung 52 weiterverarbeitet und mit innerhalb der Auswerteschaltung 52 abgespeicherten oder anderweitig vorgegebenen Parametern verglichen. Im Ergebnis werden durch die Vorgabe der Parameter Auslösekriterien definiert, bei deren Erreichen am Ausgang der Auswerteschaltung 52 ein Steuersignal abgegeben wird, als dessen Folge der Laststromkreis geschaltet, d.h. entweder eingeschaltet wird, wenn er zuvor abgeschaltet war, oder ausgeschaltet wird, wenn er zuvor eingeschaltet war.

Im Folgenden sind die mit einem solchen Aufbau realisierbaren Funktionalitäten beschrieben:
Mittels der Sensoren 31, 32 lässt sich der zeitliche Verlauf der Ströme bzw. Spannungen im Ladestromkreis erfassen und analysieren. Durch die ständige Erfassung stehen diese Signale und deren Auswerteergebnisse auch für eine regelmäßige Dokumentation zur Verfügung. Zudem können die Ausgangssignale der Sensoren 31, 32 auch über geeignete Schnittstellen anderen Komponenten des Ladekreises zur Verfügung gestellt werden. Die im Zusammenhang mit Figur 2 dargestellte Verwendung für den Energiemengenzähler 16 ist nur eine der Möglichkeiten.

Beim Überschreiten eines maximal zulässigen Amplitudenwertes im Stromverlauf wird das Schaltmittel 54 angesteuert, um einen Abschaltprozess zu bewirken, wodurch ein Überstromschutz, z.B. im Kurzschlussfall erreicht wird. Das sichere Schalten des Schaltmittels 54 kann zudem durch die Stromerfassung bzw. Spannungserfassung erkannt und überwacht werden.

Einer der von der Auswerteschaltung 52 vorgegebenen Parameter kann eine bestimmte Sicherungskennlinie sein, um eine bestimmte Strom-Zeitcharakteristik zu simulieren. Das verlangte Strom-Zeitverhalten lässt sich durch digitale Nachbildung der Kennlinie in weiten Grenzen variieren. Hierdurch kann der Überstromschutz auf bestimmte vorgebbare Auslösekennwerte eingestellt werden. Insbesondere kann vorgesehen sein, dass vorab gespeicherte Sicherungskennlinien vorgesehen sind, von denen jeweils die dem Anwendungsfall entsprechende auswählbar ist. Beispielsweise kann eine einem bestimmten Stecker des Ladekabels angepasste Kennlinie verwendet werden. So ist es beispielsweise möglich, mittels eines Steckergesichtes oder mittels eines im Stecker angeordneten Widerstandes, beispielsweise eines Widerstands zwischen einem Plug-Present- oder Pilotleiter und einem Nulleiter, einen Stecker oder ein Ladekabel für eine maximale Ladestromstärke zu kennzeichnen. Mit diesen Informationen kann auch die jeweilige Sicherungskennlinie angepasst werden. Gegenüber herkömmlichen Funktionalitäten von passiven Leitungsschutzschaltern, deren Ansprechkennlinie nicht parametriert werden kann, ergibt sich hierdurch eine weitaus größere Flexibilität. Im Rahmen dieser Funktionalität wird auch durch entsprechende Parametrierung der Ansprechkennlinie eine Kompensation des Einflusses der Umgebungstemperatur auf die Absicherungsbedingungen ermöglicht. Hierdurch soll vermieden werden, dass eine Auslösung der Einrichtung allein durch erhöhte Umgebungstemperatureinfluss erfolgt, ohne dass tatsächlich ein Fehler vorliegt. Die Auslösekennlinie der Sicherung kann auch während des Betriebs verändert werden, beispielsweise aufgrund von Erkenntnissen aus der Auswertung des angeschlossenen Kabels oder aufgrund von Erkenntnissen über Netz- und/oder Installationsengpässe.

Auch kann die digitale Auswerteeinrichtung 52 durch entsprechende Auswertung von Stromsignalen und entsprechende Differenzbildung Fehlerströme im Ladekreis erkennen und durch Ansteuerung des Schaltmittels 54 eine Abschaltung bewirken. Es können dabei sowohl Wechselstrom-Fehlerströme als auch Gleichstrom-Fehlerströme diagnostiziert werden, wodurch sich ein einem FI Schalter sowohl des Typs A als auch des Typs B entsprechendes Verhalten simulieren lässt. Von besonderer Bedeutung dabei ist, dass im Falle eines detektierten Fehlerstromes (AC oder DC) ein dauerhaftes Abschalten des Schaltmittels 54 bewirkt werden kann und erst bei einem Neustart des Ladestations-Gateway Rechners wieder aktiv eingeschaltet wird. Dabei kann die Hochlaufroutine ("Rebooting") auf diese Funktionalität angepasst sein. Hierdurch lassen sich auch die, z.B. im Bereich der Bundesrepublik Deutschland vorgeschriebenen Sicherheitsrichtlinien realisieren, die bei einem Fehlerstromschutzschalter immer ein netzspannungsunabhängiges Schalten erfordern.

Als weitere Sicherheitsfunktion von Bedeutung kann vorgesehen sein, dass im Falle eines Netzausfalls das Schaltmittel zwangsweise geöffnet wird. Auch hierdurch lässt sich die FI-Schalter-Funktionalität gewährleisten.

Auch kann nach einem Ausführungsbeispiel der Erfindung eine automatische Prüffunktion bei der FI-Schalter-Funktionalität vorgesehen sein. Dabei kann die Überwachungs- und Sicherungseinrichtung 50 angewiesen werden, einen Fehlerstrom zu simulieren. Dies kann zum Beispiel dadurch erfolgen, dass zwischen einer Phase oder einem sonstigen Leiter und dem Schutzleiter ein Widerstand gesteuert eingeschaltet wird, woraufhin das Relais des FI-Schalters angesteuert (und ggf. nicht ausgelöst) und dieses Ansteuersignal von externer Seite erkannt und somit die Funktionalität als in Ordnung befunden wird. Diese Simulation kann für alle drei Phasen getrennt und/oder in vorbestimmten Zeitabständen durchgeführt werden. Der besondere Vorteil gegenüber der bisherigen Praxis besteht nun darin, dass diese - gesetzlich zwingend vorgeschriebene - Prüffunktion automatisiert von extern erfolgt, ohne dass eine beauftragte Person an dem Ort der Ladestation anwesend sein muss. Zum Beispiel kann ein solcher Prüfvorgang jeweils nach Abschluss eines Ladevorgangs erfolgen.

Durch die zuvor beschriebene Lösung wird der Bauteile- und Verdrahtungsaufwand in der Ladestation ganz erheblich reduziert, da Doppelfunktionalitäten, wie sie bei der Verwendung separater sicherheitstechnischer Komponenten unumgänglich sind, vermieden werden.

Diese Gestaltung bietet vor allem für solche Anwendungen, wie sie bei Ladestationen für Elektrofahrzeuge gegeben sind, erheblich Vorteile, bei denen eine Energieversorgung genau einem Verbraucher gegenüber steht. Durch die hohe Flexibilität verbunden mit dem reduzierten Bauteileaufwand wird eine optimierte Anpassung der Sicherheitsanforderungen an die speziellen Anforderungen des Verbrauchers erreicht.

## Patentansprüche

1. Vorrichtung zur Bereitstellung von elektrischer Energie an einen Verbraucherstromkreis enthaltend eine dem Verbraucher separat zugeordnete Sicherungs- und Überwachungseinrichtung (50) mit einer Schalteinrichtung (54), an deren Ausgang der Verbraucherstromkreis über Anschlussmittel (10) in Form eines Ladekabels (10) anschließbar ist, wobei die Sicherungs- und Überwachungseinrichtung (50) Sensormittel (31,32) zur Erfassung mindestens einer elektrischen Größe und eine von den Sensormitteln (31,32) angesteuerte Auswerteeinrichtung (52) aufweist, welche Parametrierungsmittel zur voreinstellbaren Vorgabe mindestens eines sicherheitsrelevanten Auslösekriteriums enthält,
wobei die Sicherungs- und Überwachungseinrichtung (50) ein Überstromüberwachungsmittel aufweist, welches die Größe des bereitgestellten elektrischen Stromes detektiert,
wobei von den Parametrierungsmittel mindestens eine Strom- Zeitcharakteristik für den zulässigen Stromverlauf vorgegeben ist,
wobei die Strom- Zeitcharakteristik einer vorgebbaren Sicherungskennlinie mit einer Mehrzahl von Auslösekriterien entspricht,
wobei ein Stecker (11) des Ladekabels (10) oder das Ladekabel (10) mittels eines in dem Stecker (11) angeordneten Widerstands oder mittels eines Steckergesicht für eine maximale Ladestromstärke gekennzeichnet ist, und
wobei mittels der Kennzeichnung von Stecker (11) oder Ladekabel (10) eine von mehreren vorab gespeicherten Sicherungskennlinien auswählbar ist,
wobei beim Erreichen von mindestens einem sicherheitsrelevanten Auslösekriterium der ausgewählten Sicherungskennlinie die Schalteinrichtung (54) den Verbraucherstromkreis trennt, wobei die Schalteinrichtung (54) ein Leistungsstromschalter in Form eines Relais und/oder eines Schützes ist.

2. Vorrichtung nach Anspruch 1, **dadurch gekennzeichnet, dass** von den Parametrierungsmitteln ein im Verbraucherstromkreis maximal zulässiger Stromwert vorgebbar ist.

3. Vorrichtung nach Anspruch 1, **dadurch gekennzeichnet, dass** die Sicherungs- und Überwachungseinrichtung (50) ein Fehlerstromüberwachungsmittel aufweist.

4. Vorrichtung nach Anspruch 3, **dadurch gekennzeichnet, dass** das Fehlerstromüberwachungsmittel das Auftreten eines Wechselstrom-Fehlerstroms überwacht (FI-Schalter des Typs A), oder das Fehlerstromüberwachungsmittel das Auftreten eines Gleichstrom-Fehlerstroms überwacht (FI-Schalter des Typs B).

5. Vorrichtung nach Anspruch 1, **dadurch gekennzeichnet, dass** das Sensormittel (31,32) ein Hallsensor ist oder das Sensormittel (31,32) ein Stromwandler ist.

6. Vorrichtung nach einem der Ansprüche 1 bis 5, **dadurch gekennzeichnet, dass** ein von einer Energieversorgungseinrichtung (13) gespeister und der Sicherungs- und Überwachungseinrichtung vorgeordneter Energiemengenzähler (16) vorgesehen ist.

7. Vorrichtung nach Anspruch 1, **dadurch gekennzeichnet, dass** jedem Verbraucher ein separater Energiemengenzähler (16) zugeordnet ist.

8. System mit einer Vorrichtung nach einem der vorstehenden Ansprüche, **dadurch gekennzeichnet, dass** der Verbraucher die Batterie eines Elektrofahrzeugs ist und dass die Vorrichtung zur Bereitstellung von elektrischer Energie eine Ladestation für ein Elektrofahrzeug ist.

9. System nach Anspruch 8, **dadurch gekennzeichnet, dass** die Sicherungsund Überwachungseinrichtung (50) als eines ihrer Eingangssignale das "Plug Present" Signal einer Ladesteuerungsschaltung erhält.

10. System nach einem der vorstehenden Ansprüche 8 und 9, **dadurch gekennzeichnet, dass** Sicherungs- und Überwachungseinrichtung (50) eine Auslösekennlinie aufweist, welche während des Betriebs veränderbar ist.

11. Verfahren zur Bereitstellung von elektrischer Energie an den Ladestromkreis eines Elektrofahrzeugs von einer Vorrichtung zur Bereitstellung von elektrischer Energie enthaltend eine dem Ladestromkreis separat zugeordnete Sicherungs- und Überwachungseinrichtung (50) mit einer Schalteinrichtung (54), an deren Ausgang der Ladestromkreis über Anschlussmittel (10) in Form eines Ladekabels (10) anschließbar ist durch
- Erfassen mindestens einer elektrischen Größe im Ladestromkreis und deren Weiterleitung an eine Auswerteeinrichtung,
- Vorgabe eines Parameters für mindestens ein sicherheitsrelevantes Auslösekriterien in der Auswerteeinrichtung,
- gesteuertes Trennen durch die Schalteinrichtung (54) des Ladestromkreises beim Erreichen des mindestens einen sicherheitsrelevanten Auslösekriteriums,
- wobei die Sicherungs- und Überwachungseinrichtung (50) ein Überstromüberwachungsmittel aufweist, welches die Größe des bereitgestellten elektrischen Stromes detektiert,
- wobei von den Parametrierungsmittel mindestens eine Strom- Zeitcharakteristik für den zulässigen Stromverlauf vorgegeben wird,
- wobei eine Strom- Zeitcharakteristik einer vorgebbaren Sicherungskennlinie mit einer Mehrzahl von Auslösekriterien entspricht,
- wobei ein Stecker (11) des Ladekabels (10) oder das Ladekabel (10) mittels eines in dem Stecker (11) angeordneten Widerstands oder mittels eines Steckergesicht für eine maximale Ladestromstärke gekennzeichnet ist, und
- wobei mittels der Kennzeichnung von Stecker (11) oder Ladekabel (10) eine von mehreren vorab gespeicherten Sicherungskennlinien ausgewählt wird, wobei die Schalteinrichtung (54) ein Leistungsstromschalter in Form eines Relais und/oder eines Schützes ist.

12. Verwendung der Vorrichtung zur Bereitstellung von elektrischer Energie nach einem der vorstehenden Ansprüche 1 bis 7 in Form einer Ladestation beim Ladevorgang der Batterie eines Elektrofahrzeuges (2).

## Claims

1. An apparatus for providing electrical energy to a consumer circuit, comprising a safety and monitoring device (50) separately assigned to the consumer and having a switching device (54), to the output of which the consumer circuit is connectable via connecting means (10) in the form of a charging cable (10), wherein the safety and monitoring device (50) comprises sensor means (31, 32) for detecting at least one electrical quantity and an evaluation device (52) which is driven by the sensor means (31, 32), which comprises parameterization means for the presettable specification of at least one safety-relevant triggering criterion,
wherein the safety and monitoring device (50) comprises an overcurrent monitoring means which detects the magnitude of the provided electrical current,
wherein at least one current-time characteristic for the permissible current profile is predetermined by the parameterization means,
wherein the current-time characteristic corresponds to a predeterminable fuse characteristic with a plurality of triggering criteria,
wherein a plug (11) of the charging cable (10) or the charging cable (10) is **characterized by** means of a resistor arranged in the plug (11) or by means of a plug face for a maximum charging current strength, and
wherein one of a plurality of previously stored fuse characteristics is selected by means of the characterization of the plug (11) or charging cable (10),
wherein, when at least one safety-relevant trigger criterion of the selected fuse characteristic is reached, the switching device (54) disconnects the consumer circuit, wherein the switching device is a power switch in the form of a relay and/or a contactor.

2. The apparatus according to claim 1, **characterized in that** a maximum permissible current value in the consumer circuit is predeterminable by the parameterization means.

3. The apparatus according to claim 1, **characterized in that** the safety and monitoring device (50) comprises a residual current monitoring means.

4. The apparatus according to claim 3, **characterized in that** the residual current monitoring means monitors the occurrence of an AC residual current (FI switch of the type A), or the residual current monitoring means monitors the occurrence of a DC residual current (FI switch of the type B).

5. The apparatus according to claim 1, **characterized in that** the sensor means (31, 32) is a Hall sensor or the sensor means (31, 32) is a current transformer.

6. The apparatus according to one of claims 1 to 5, **characterized in that** an energy quantity meter (16) fed by an energy supply device (13) and arranged upstream of the safety and monitoring device is provided.

7. The apparatus according to claim 1, **characterized in that** a separate energy quantity meter (16) is associated with each consumer.

8. A system comprising an apparatus according to any of the above claims, **characterized in that** the consumer is the battery of an electric vehicle and that the apparatus for providing electrical energy is a charging station for an electric vehicle.

9. The system according to claim 8, **characterized in that** the protection and monitoring device (50) receives as one of its input signals the "plug present" signal of a charge control circuit.

10. The system according to one of the above claims 8 and 9, **characterized in that** the safety and monitoring device (50) comprises a triggering characteristic which is changeable during the operation.

11. A method for providing electrical energy to the charging circuit of an electric vehicle from an apparatus for providing electrical energy, comprising a safety and monitoring device (50) separately assigned to the charging circuit with a switching device (54), to the output of which the charging circuit is connectable via connecting means (10) in the form of a charging cable (10) by
- detecting of at least one electrical quantity in the charging circuit and its transmission to an evaluation device,
- specification of a parameter for at least one safety-relevant triggering criterion in the evaluation device,
- controlled disconnecting by the switching device (54) of the charging circuit when the at least one safety-relevant triggering criterion is reached,
- wherein the protection and monitoring device (50) comprises an overcurrent monitoring means which detects the magnitude of the provided electrical current,
- wherein at least one current-time characteristic for the permissible current profile is specified by the parameterization means,
- wherein a current time characteristic corresponds to a predeterminable fuse characteristic with a plurality of triggering criteria,
- wherein a plug (11) of the charging cable (10) or the charging cable (10) is **characterized by** means of a resistor arranged in the plug (11) or by means of a plug face for a maximum charging current, and
- wherein by means of the characterization of the plug (11) or charging cable (10), one of several previously stored fuse characteristics is selected, wherein the switching device (54) is a power switch in the form of a relay and/or a contactor.

12. A use of the apparatus for providing electrical energy according to any of the above claims 1 to 7 in the form of a charging station during the charging process of the battery of an electric vehicle (2).

## Revendications

1. Procédé de fourniture d'énergie électrique à un circuit utilisateur contenant un dispositif de sécurité et de surveillance (50) disposé séparément de l'utilisateur comprenant un dispositif de commutation (54), sur lequel la sortie du circuit utilisateur peut être raccordé par un moyen de raccordement (10) sous forme d'un câble électrique (10), où le dispositif de sécurité et de surveillance (50) comprend un capteur (31, 32) pour la détection d'au moins une valeur électrique et un dispositif d'évaluation (52) piloté par un des capteurs (31, 32), qui comprend un moyen de paramétrage pour consigne préprogrammable d'au moins un critère de déclenchement important pour la sécurité,
où le dispositif de sécurité et de surveillance (50) présente un moyen de surveillance de surtension, qui détecte l'amplitude du courant électrique fourni,
où le moyen de paramétrage donne au moins une caractéristique temporelle du courant pour un trajet de courant autorisé,
où la caractéristique temporelle de courant correspond à une courbe caractéristique de sécurité prédéfinie avec plusieurs critères de déclenchement,
où une fiche (11) du câble électrique (10) ou le câble électrique (10) est caractérisé pour une puissance maximale de courant de charge au moyen d'une résistance dans la fiche (11) ou une protection de fiche, et
où une ou plusieurs courbes caractéristiques de sécurité préalablement enregistrées peuvent être choisies au moyen de la caractérisation de la fiche (11) ou du câble électrique (10),
où lorsque l'on atteint au moins un critère de déclenchement important pour la sécurité de la courbe caractéristique choisie, le dispositif de commutation (54) sépare le circuit utilisateur, le dispositif de commutation (54) étant un interrupteur de courant de puissance sous la forme d'un relais et/ou d'un contacteur.

2. Dispositif selon la revendication 1, **caractérisé en ce qu'**une valeur de courant maximale autorisée dans le circuit utilisateur peut être définie par le moyen de paramétrage.

3. Dispositif selon la revendication 1, **caractérisé en ce que** le dispositif de sécurité et de surveillance (50) présente un moyen de surveillance de courant de défaut.

4. Dispositif selon la revendication 3, **caractérisé en ce que** le moyen de surveillance de courant de défaut détecte la survenue d'un courant de défaut de courant alternatif (commutateur FI de type A) ou **en ce que** le moyen de surveillance de courant de défaut détecte la survenue d'un courant de défaut de courant continu (commutateur FI de type B).

5. Dispositif selon la revendication 1, **caractérisé en ce que** le capteur (31, 32) est un capteur à effet Hall ou **en ce que** le capteur (31, 32) est un transformateur.

6. Dispositif selon l'une des revendications 1 à 5, **caractérisé en ce qu'**un compteur électrique (16) alimenté par un dispositif d'alimentation électrique (13) et agencé avant le dispositif de sécurité et de surveillance est prévu.

7. Dispositif selon la revendication 1, **caractérisé en ce que** chaque utilisateur est associé à un compteur électrique (16) distinct.

8. Système comportant un dispositif selon l'une des revendications précédentes, **caractérisé en ce que** l'utilisateur est une batterie de véhicule électrique et **en ce que** le dispositif pour la fourniture d'énergie électrique est un poste de charge pour un véhicule électrique.

9. Système selon la revendication 8, **caractérisé en ce que** le dispositif de sécurité et de surveillance (50) contient comme un de ses signaux d'entrée, le signal « Plus Présent » d'un commutateur de commande de charge.

10. Système selon l'une des revendications 8 et 9 précédentes, **caractérisé en ce que** le dispositif de sécurité et de surveillance (50) présente une courbe caractéristique de déclenchement, qui peut être modifiée pendant le fonctionnement.

11. Procédé de fourniture d'énergie électrique au circuit de charge d'un véhicule électrique d'un dispositif de fourniture d'énergie électrique contenant un dispositif de sécurité et de surveillance (50) agencé séparément du circuit de charge, comprenant un dispositif de commutation (54), sur lequel la sortie du circuit de charge peut être raccordé par un moyen de raccordement (10) sous forme d'un câble électrique (10), par
- la détection d'au moins une valeur électrique dans le circuit de charge et son acheminement à un dispositif d'évaluation,
- la consigne d'un paramètre pour au moins un critère de déclenchement important pour la sécurité dans le dispositif d'évaluation,
- la séparation commandée par le dispositif de commutation (54) du circuit de charge lorsque l'on atteint l'au moins un critère de déclenchement important pour la sécurité,
- où le dispositif de sécurité et de surveillance (50) présente un moyen de surveillance de surtension, qui détecte l'amplitude du courant électrique fourni,
- où le moyen de paramétrage donne au moins une caractéristique temporelle du courant pour un trajet de courant autorisé,
- où la caractéristique temporelle de courant correspond à une courbe caractéristique de sécurité prédéfinie avec plusieurs critères de déclenchement,
- où une fiche (11) du câble électrique (10) ou le câble électrique (10) est caractérisé pour une puissance maximale de courant de charge au moyen d'une résistance dans la fiche (11) ou une protection de fiche, et
- où une ou plusieurs courbes caractéristiques de sécurité préalablement enregistrées peuvent être choisies au moyen de la caractérisation de la fiche (11) ou du câble électrique (10), où le dispositif de commutation (54) est un interrupteur de courant de puissance sous la forme d'un relais et/ou d'un contacteur.

12. Utilisation du dispositif de fourniture d'énergie électrique selon l'une des revendications 1 à 7 précédentes, sous forme d'un poste de charge lors du processus de charge de la batterie d'un véhicule électrique (2).
